Europäisches Patentamt

European Patent Office

Office européen des brevets

(19)

(11) Publication number: **0 080 798**
**B1**

(12) **EUROPEAN PATENT SPECIFICATION**

(45) Date of publication of patent specification: **09.04.86**

(51) Int. Cl.⁴: **B 65 H 3/46**

(21) Application number: **82305143.8**

(22) Date of filing: **29.09.82**

(54) **Method for feeding recording sheet materials and apparatus therefor.**

(30) Priority: **26.11.81 JP 189698/81**
**08.07.82 JP 118923/82**

(43) Date of publication of application:
**08.06.83 Bulletin 83/23**

(45) Publication of the grant of the patent:
**09.04.86 Bulletin 86/15**

(84) Designated Contracting States:
**DE FR GB**

(56) References cited:
**AT-B- 331 265**
**DE-B-2 647 841**
**US-A-3 635 468**
**US-A-4 003 567**
**US-A-4 310 151**

(73) Proprietor: **MITSUBISHI PAPER MILLS, LTD.**
**4-2, Marunouchi 3-chome**
**Chiyoda-ku Tokyo 100 (JP)**

(73) Proprietor: **DAINIPPON SCREEN MFG., CO., LTD.**
**1-1, Tenjinkitacho**
**Horikawadoriteranouchiagaru-4-chome**
**Kamikyo-ku Kyoto-shi Kyoto-fun (JP)**

(72) Inventor: **Senga, Takao c/o Kyoto-Factory**
**Mitsubishi Paper Mills, Ltd. 6-6, Kaiden-1-chome**
**Nagaokakyo-shi (JP)**
Inventor: **Yamada, Jun c/o Kyoto-Factory**
**Mitsubishi Paper Mills, Ltd. 6-6, Kaiden-1-chome**
**Nagaokakyo-shi (JP)**
Inventor: **Kuriu, Sadao c/o Kyoto-Factory**
**Mitsubishi Paper Mills, Ltd. 6-6, Kaiden-1-chome**
**Nagaokakyo-shi (JP)**
Inventor: **Suzuki, Shigeyoshi c/o Kyoto-Factory**
**Mitsubishi Paper Mills, Ltd. 6-6, Kaiden-1-chome**
**Nagaokakyo-shi (JP)**

(74) Representative: **Ford, Michael Frederick et al**
**MEWBURN ELLIS & CO. 2/3 Cursitor Street**
**London EC4A 1BQ (GB)**

Courier Press, Leamington Spa, England.

# Description

This invention relates to a method for feeding recording sheet materials, especially those having a hard support, such as an aluminium plate (preferably, photo-sensitive printing plate materials) to subsequent steps, normally, to an exposing step, and to an apparatus therefor.

There are known various image recording materials having a photosensitive substance on a support. The photosensitive substances may be roughly classified into silver salts (silver halide emulsions) and non-silver salts (e.g. inorganic or organic photo-conductive substances for electrophotography, diazonium compounds, photo-sensitive resins, etc) and suitable photosensitive substances may be chosen depending on purpose and use.

It is also known to use image recording materials as printing plate materials. As support for the image recording materials, there may be used various supports such as paper, polyolefin resin-coated paper, various films, metallic plates such as aluminium or zinc, glass plates, composites thereof etc. When especially high printing endurance is required as a support for printing plates, a support which is less elastic and harder than paper, e.g. an aluminium plate is used. For example, representative of those practically used are the so-called presensitized plates (PS plates) which comprise a photo-sensitive layer containing a diazonium compound provided on an anodized aluminium plate; printing plates according to an electrophotographic process in which is provided a photo-sensitive layer containing zinc oxide, selenium or various organic photo-conductive substances; printing plates in which silver images transferred according to a silver complex diffusion transfer process are used as printing ink receptive areas; etc.

Other practically used printing plates are, for example, lithographic printing plates made by an electrophotographic process using zinc oxide and silver salt lithographic plates made by a silver complex diffusion transfer process, a hardening development process, etc, which use paper or polyolefin resin-coated paper as a support. They have high photosensitivity and so are suitable for direct plate-making. Thus it is possible to automate the steps from exposure to plate-making. The materials are fed in the form of roll and can be cut by an automatic cutter.

However, in the case of relatively hard supports which cannot be made into a roll or cannot be readily automatically cut, they must be supplied as a sheet. Sheet materials of such relatively hard support are liable to damage of their photo-sensitive layer during production, transportation or use thereof. In order to prevent damage to the photo-sensitive layer and further prevent blocking of the sheet materials and deterioration of photo-sensitive characteristics, it is known to put a sheet usually of paper (hereinafter called a "spacing sheet") on the surface of the photo-sensitive layer of the sheet materials (this combination of a sheet material and a spacing sheet is called a "unit" hereinafter) and a plurality of these units are packaged.

In the case of the conventional packages of units as mentioned above, for example, in the case of PS plates, the spacing sheets are manually removed at every exposing operation and after removal of the spacing sheet, exposure is carried out. However, such manual operation is troublesome. Furthermore, employment of such units has prevented production of printing plate materials for direct plate-making by automation as referred to hereinbefore.

If there is a method which can feed to an exposing step only the printing plate sheet materials of the units mounted on an automatic plate-making apparatus, such method will be especially useful for direct printing plate making according to an electrophotographic process or silver salt process. Moreover, such a feeding method will accelerate automation of production of PS plates and the like. Furthermore, such feeding method will make it possible to automate the production of not only the printing plates, but the image recording materials.

An object of this invention is to provide a method for efficiently feeding recording sheet materials having a relatively hard support without damaging the photosensitive layer and without any manpower for this purpose.

Another object of this invention is to provide a simple and highly efficient method for feeding printing plate sheet materials having a relatively hard support for direct plate-making in an automatic platemaking apparatus with safe keeping qualities of the resultant printing plates.

According to this invention, there is provided a method for feeding image recording sheet material which comprises piling composite units, each of which comprises a combination of an image recording sheet material having a relatively hard support and a spacing sheet put on said sheet material, in such a manner that the leading edge portion of the image recording sheet material protrudes beyond the leading edge of the spacing sheet and the trailing edge portion of the spacing sheet protrudes beyond the trailing edge of the image recording sheet material, holding the trailing edge portions of the spacing sheets so as not to be fed, and applying a feeding means to the leading edge portions of the image recording sheet material to feed only this sheet material.

According to another aspect of the invention we provide an apparatus for feeding recording sheet material which includes a pile of composite units each of the units comprising a combination of an image recording sheet material having a relatively hard support and a spacing sheet put on said sheet material in such a manner that the leading edge portion of the image recording sheet material protrudes beyond the leading edge of the spacing sheet and the trailing edge portion of the spacing sheet protrudes beyond the trailing edge of the image recording sheet material, means to hold the trailing edge portions of the spacing sheets so as not to be fed, and feeding means to act on the leading edge portions of the image recording sheet material and thus feed only the said sheet material to a printing plate making apparatus.

Alternatively, the leading edge of the image recording sheet material and the leading edge of the spacing sheet can be aligned when a cut portion is provided in the leading edge portion of the spacing sheet. Thus, the units can be automatically and efficiently produced. That is, there is also provided a method for feeding image recording sheet material which comprises piling composite units, each of which comprises a combination of an image recording sheet material having a relatively hard support and a spacing sheet put on said sheet material in such a manner that the trailing edge portion of the spacing sheet protrudes beyond the trailing edge of the image recording sheet material, said spacing sheet having a cut portion in the leading edge portion so that the image recording sheet material thereunder can receive feeding means at the exposed portion, holding the trailing edge portion of the spacing sheets being held so that the spacing sheets cannot be fed with the image recording sheet material and applying a feeding means to the exposed portion of the image recording sheet material through the cut portion of the spacing sheet to feed only this sheet material.

According to this alternative aspect of the invention there is also provided an apparatus for feeding recording sheet material which includes a pile of composite units each of the units comprising a combination of an image recording sheet material having a relatively hard support and a spacing sheet put on said sheet material and having a cut portion in the leading edge portion in such a manner that the trailing edge portion of the spacing sheet protrudes beyond the trailing edge of the image recording sheet material, means to hold the trailing edge portions of the spacing sheets so as not to be fed, and feeding means to act on the leading edge portions of the image recording sheet material through the cut portion of the spacing sheet and thus feed only the said sheet material to a printing plate making apparatus.

The method and the apparatus of this invention will be further explained with reference to the drawings which diagrammatically illustrate only the feeding portion of the apparatus.

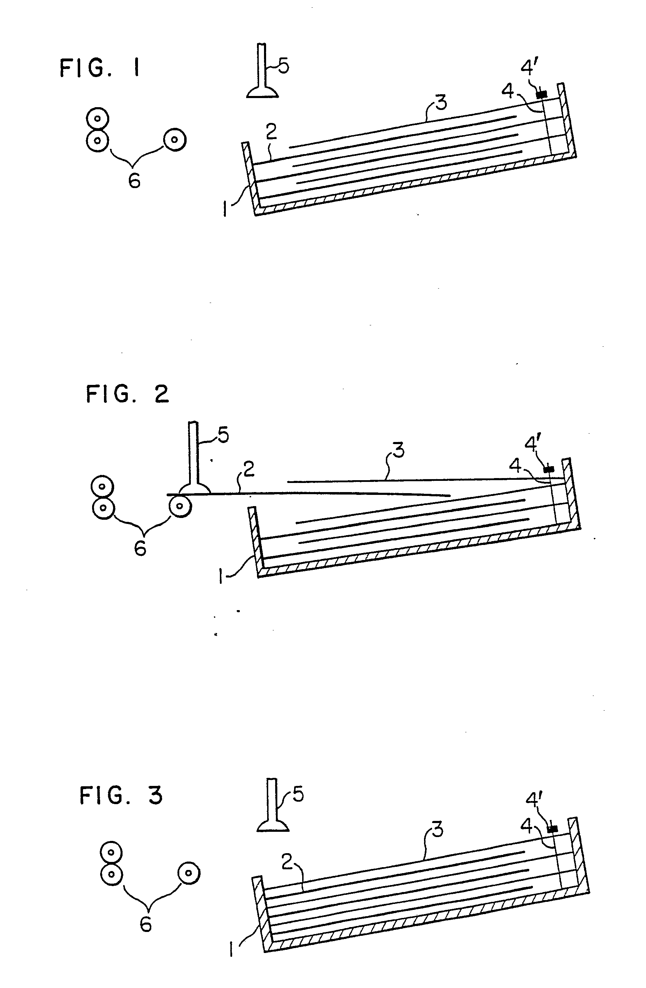

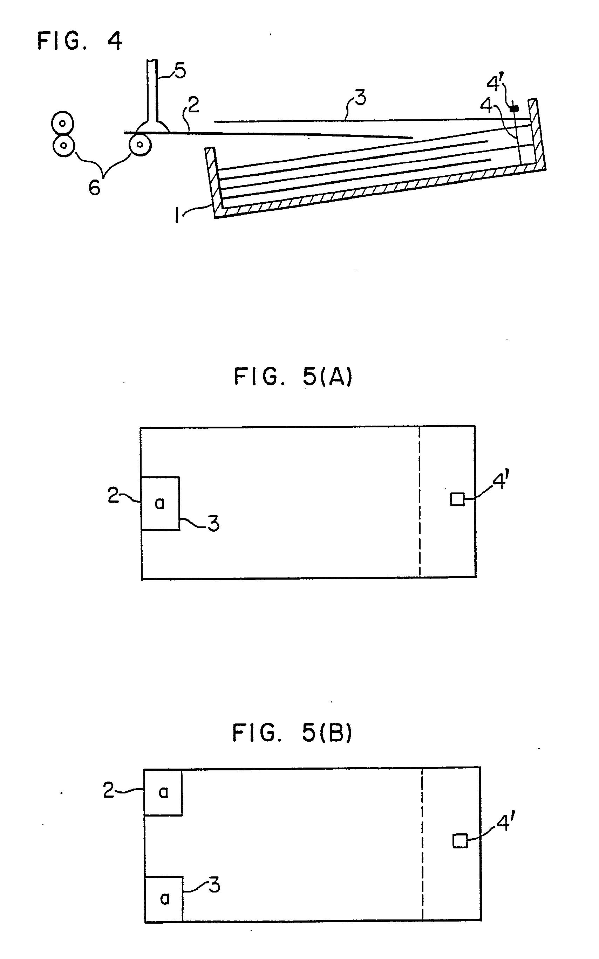

Figure 1 shows the state before feeding the recording sheet material 2, Figure 2 shows the state during the feeding of the recording sheet material to carrying rolls 6, Figure 3 shows another embodiment of this invention where a cut portion is provided in the leading edge portion of the spacing sheets, usually paper, and the leading edge of the image recording sheet material and that of the spacing sheets are aligned, and Figure 4 shows the state of feeding the image recording sheet material provided as shown in Figure 3 to the carrying rolls 6. In tray 1 there are provided one or more holding rods 4 for holding the trailing edge portions of spacing sheets 3 so that the spacing sheets cannot be fed and a set screw 4' for preventing the spacing sheets from escaping from the holding rod. Figures 5(A) and 5(B) are top views of the unit comprising recording sheet material 2 and spacing sheets 3 as shown in Figure 3 and a modified form of Figure 3. Portion a corresponds to the cut portion of spacing sheets 3 and it is seen that sheet material 2 of that portion just below the spacing sheet 3 is shown. Suction chuck 5 as a feeding means is applied to said portion a of recording sheet material 2. The trailing edge portions of spacing sheet 3 protrude beyond the trailing edges of recording sheet material 2 and the spacing sheets 3 are held at their trailing edge portion by holding rod 4 which passes through a hole made in the trailing edge portions of spacing sheets 3. If necessary, escape of the spacing sheets can be prevented by set screw 4'.

For providing the composite units as shown in Figure 1, the leading edge portion of each recording sheet material 2 is protruded beyond the leading edge of spacing sheet 3, the length of the protruded leading edge portion of the sheet material 2 being at least such that suction chuck 5 can be applied thereto. On the other hand, the trailing edge portions of spacing sheets 3 protrude beyond the trailing edge of recording sheet material 2 and are held by holding rod 4 which passes through a hole made in the trailing edge portions of spacing sheets 3. If necessary, escape of the spacing sheets can be prevented by set screw 4'.

In order to transfer the recording sheet material 2 from the units provided as shown in Figure 1 and Figure 3, through carrying rolls 6, to an exposing section of printing plate making apparatus the leading edge portion (portion a in Figures 5a and 5b) of recording sheet material 2 is lifted by suction chuck 5 and simultaneously the sheet material is fed to carrying rolls 6 by this suction chuck (Figures 2 and 4). The trailing edge of recording sheet material 2 slides over spacing sheet 3 thereunder and so it does not damage the surface of the photo-sensitive layer of recording sheet material 2 thereunder. If necessary, it is also possible to apply another suction chuck to the trailing portion of the sheet material during the feeding of the sheet material by suction chuck 5. After feeding of all the recording sheet material, only the spacing sheets remain in tray 1.

The accompanying drawings show one preferred embodiment of this invention where the composite units (and the tray) are inclined downwardly at the leading edge with reference to the plane axis of recording sheet material 2 (horizontal plane axis in the drawings).

According to this method, the leading edges of recording sheet material 2 align along the wall surface of tray 1. This is suitable for carrying out the feeding method of this invention and the leading edge portion of recording sheet material 2 is lifted and the sheet material can be horizontally fed. However, tray 1 may be placed in a horizontal position. Furthermore, tray 1 is not necessarily needed and may be merely a stand on which the plural units are piled. Moreover, tray 1 may be a cassette which contains the units and whose upper front part is preferably an openable or removable lid. The cassette may be of any material, but preferably of metal or plastics.

The feeding means for recording sheet material is preferably a suction chuck 5 as shown in the drawings, but may be another form of conveying means, such as a roller system. One or two or more feeding means may be used.

Means for holding the trailing edge portions of spacing sheets 3 is not limited to a holding rod 4 as shown in the drawings. When the thickness of the units is not so large, it is not so difficult to put together the trailing edge portions of spacing sheets 3 and hold them. Simply, the trailing edge portions of spacing sheets 3 may be merely put together and held by stapling, etc. and preferably this is held to tray 1 by adhesive tapes. Furthermore, holding rod 4 shown in the drawings may be replaced by a pin or a nail.

By providing a cut portion in the leading edge portions of spacing sheets 3, the leading edges of sheet material 2 and those of spacing sheet 3 can be aligned at the time of assembling the units and thus the units can be automatically made with cutting spacing sheets 3 by an automatic cutter.

Since the units can be automatically assembled by aligning the leading edges of recording sheet material 2 and those of spacing sheets 3 as mentioned above, ease of assembly of spacing sheets increases, and moreover since most of the surface of the under recording sheet 2 is physically isolated by spacing sheets 3 having a cut portion, damage of the edge portion of recording sheet material 2 can be prevented.

The cut portion is preferably provided at the centre of the leading edge portions of the spacing sheets, and is of such a size that the feeding means can be applied to the exposed portion of the sheet material, but there is no limitation as to the position thereof, number (it may be provided at both edges) (Figure 5(B)) or shape. For example, they may be such as shown in Figures 5(A) and 5(B).

The spacing sheet 3 used in this invention is usually an ordinary paper made from wood pulp, but there is no limitation in materials as long as they meet the object of the spacing sheet for the recording sheet materials. The term "spacing sheets" includes ordinary paper, thin sheets of synthetic resins such as polyethylene, polypropylene, etc. In the case of the embodiment as shown in Figure 1 the length of spacing sheet 3 may be identical with or different from that of recording sheet material 2. (Too short a spacing sheet does not meet the original object as a spacing sheet).

The supports of the recording sheet materials used in this invention are especially preferably metallic supports such as aluminium sheet, composites of aluminium and film and the like.

However, the supports used in this invention include relatively hard supports such as reinforced papers, thick or reinforced synthetic resin films which must be made into sheet because they cannot be rolled or are difficult to cut by automatic cutters like said metallic supports.

The image recording layer provided on the relatively hard support can be any of the known ones as mentioned hereinbefore. When the support is a hard support such as an aluminium support, it is preferably an image recording layer for printing plates. However, it may be an image forming material comprising an aluminium sheet which contains silver halide in fine pores formed by anodization.

The recording sheet materials fed by the method of this invention are usually transferred to an exposing step where they are imagewise exposed. Moreover, in the same apparatus, treatments such as development, fixing, washing with water, etc. may be successively carried out and if necessary, desensitizing treatment, gum coating treatment, etching treatment (e.g. a treatment for removing non-toner image areas of printing plates which use organic photo-conductive substances), etc. may also be carried out. Of course, some of these steps may be carried out in other apparatus because of problems in design of the apparatuses.

According to the feeding method of this invention, the recording sheet materials can be simply, efficiently, automatically and successively fed without damaging the photosensitive surface even if the size of the sheet material is large.

**Claims**

1. A method for feeding recording sheet material which comprises piling composite units, each of which comprises a combination of an image recording sheet material (2) having a relatively hard support and a spacing sheet (3) put on said sheet material, in such a manner that the leading edge portion of the image recording sheet material (2) protrudes beyond the leading edge of the said spacing sheet (3) and the trailing edge portion of the spacing sheet (3) protrudes beyond the trailing edge of the image recording sheet material, holding the trailing edge portions of the spacing sheets so as not to be fed, and applying a feeding means (5) to the leading edge portions of the image recording sheet material to feed only the said sheet material to a subsequent step.

2. A method for feeding recording sheet material which comprises piling composite units, each of which comprises a combination of an image recording sheet material (2) having a relatively hard support and a spacing sheet (3) put on said sheet material and having a cut portion (a) in the leading edge portion, in such a manner that the trailing edge portion of the spacing sheet protrudes beyond the trailing edge of the image recording sheet material, holding the trailing edge portions of the spacing sheets (3) so as not to be fed, and applying a feeding means (5) to the leading edge portions of the image recording sheet material (2) through the cut portion (a) of the spacing sheet (3) to feed only the said sheet material (3) to a subsequent step.

3. A method for feeding recording sheet material according to claim 1 or claim 2, wherein the recording sheet material is sheet material for printing plates.

4. A method for feeding recording sheet material according to any preceding claim wherein the support is a metal sheet such as aluminium sheet.

5. A method for feeding recording sheet material according to any preceding claim, wherein the composite units are placed so that they are inclined downwardly at the leading edge relative to the axis of the feeding plane.

6. A method for feeding recording sheet material according to any preceding claim, wherein the feeding means is a suction chuck.

7. A method for feeding recording sheet material according to claim 5, wherein the composite units are placed in a tray (1) inclined downwardly at the leading edge.

8. A method for feeding recording sheet material according to any preceding claim, wherein the image recording sheet material (2) is fed to an exposing section.

9. An apparatus for feeding recording sheet material which includes a pile of composite units each of the units comprising a combination of an image recording sheet material (2) having a relatively hard support and a spacing sheet (3) put on said sheet material in such a manner that the leading edge portion of the image recording sheet material (2) protrudes beyond the leading edge of the spacing sheet (3) and the trailing edge portion of the spacing sheet (3) protrudes beyond the trailing edge of the image recording sheet material (2), means (4, 4') to hold the trailing edge portions of the spacing sheets (3) so as not to be fed, and feeding means (5) to act on the leading edge portions of the image recording sheet material (2) and thus feed only the said sheet material (2) to a printing plate making apparatus.

10. An apparatus for feeding recording sheet material which includes a pile of composite units each of the units comprising a combination of an image recording sheet material (2) having a relatively hard support and a spacing sheet (3) put on said sheet material and having a cut portion (a) in the leading edge portion in such a manner that the trailing edge portion of the spacing sheet (3) protrudes beyond the trailing edge of the image recording sheet material (2), means (4, 4') to hold the trailing edge portions of the spacing sheets (3) so as not to be fed, and feeding means (5) to act on the leading edge portions of the image recording sheet material (2) through the cut portion (a) of the spacing sheet (3) and thus feed only the said sheet material (2) to a printing plate making apparatus.

## Revendications

1. Procédé d'amenage de matière d'enregistrement en feuilles, caractérisé en ce qu'on empile des unités composites dont chacune est constituée par une combinaison d'une feuille de matière d'enregistrement d'image (2) à support relativement dur et d'une feuille de séparation (3) placée sur la feuille de matière d'enregistrement, de façon que la portion marginale de tête de la feuille de matière d'enregistrement d'image (2) fasse saillie au-delà du bord de tête de la feuille de séparation (3) et que la portion marginale de queue de la feuille de séparation (3) fasse saillie au-delà du bord de queue de la feuille de matière d'enregistrement d'image, en ce qu'on retient les portions marginales de queue des feuilles de séparation de façon qu'elles ne soient pas transportées, et en ce que l'on fait agir un dispositif de transport (5) sur les portions marginales de tête des feuilles de matière d'enregistrement d'image, de façon à ne transférer à un stade subséquent que ces feuilles de matière d'enregistrement.

2. Procédé d'amenage de matières d'enregistrement en feuilles, caractérisé en ce qu'on empile des unités composites dont chacune est constituée par une combinaison d'une feuille de matière d'enregistrement d'image (2) à support relativement dur et d'une feuille de séparation (3) placée sur la feuille de matière d'enregistrement, et comportant une découpure (a) dans sa portion marginale de tête, de façon que la portion marginale de queue de la feuille de séparation fasse saillie au-delà du bord de queue de la feuille de matière d'enregistrement d'image, en ce qu'on retient les portions marginales de queue des feuilles de séparation (3) de façon qu'elles ne soient pas transportées, et en ce que l'on fait agir un dispositif de transport (5) sur les portions marginales de tête des feuilles de matière d'enregistrement d'image (2), à travers la découpure (a) de la feuille de séparation (3), pour ne transférer que les feuilles de matière d'enregistrement (3) à un stade subséquent.

3. Procédé selon la revendication 1 ou 2, caractérisé en ce que la matière d'enregistrement en feuilles est une matière en forme de feuilles pour plaques d'impression (ou plaques offset, ou clichés).

4. Procédé selon l'une quelconque des revendications précédentes, caractérisé en ce que le support est une feuille de métal, par exemple une feuille d'aluminium.

5. Procédé selon l'une quelconque des revendications précédentes, caractérisé en ce qu'on place les unités composites de façon qu'elles soient inclinées vers le bas, au bord de tête, par rapport à la direction du plan de transport.

6. Procédé selon l'une quelconque des revendications précédentes, caractérisé en ce que le dispositif de transport est un mandrin aspirant.

7. Procédé selon la revendication 5, caractérisé en ce qu'on place les unités composites dans un plateau (1) incliné vers la bas au bord de tête.

8. Procédé selon l'une quelconque des revendications précédentes, caractérisé en ce qu'on transfére les feuilles de matière d'enregistrement d'image (2) à une section d'exposition.

9. Appareil d'amenage de matière d'enregistrement en feuilles, caractérisé en ce qu'il comprend une pile d'unités composites constituées chacune par une combinaison d'une feuille de matière d'enregistrement d'imge (2) à support relativement dur et d'une feuille de séparation (3) placée sur ladite feuille de matière d'enregistrement, de façon que la portion marginale de tête de la feuille de matière d'enregistrement d'image (2) fasse saillie au-delà du bord de tête de la feuille de séparation (3) et que la portion marginale de queue de la feuille de séparation (3) fasse saillie au-delà du bord de queue de la feuille de matière d'enregistrement d'image (2), des moyens (4, 4') pour retenir les portions marginales de queue des feuilles de séparation (3) de façon qu'elles ne soient pas transportées, et un dispositif de transport (5) devant agir sur les portions marginales de tête des feuilles de matière d'enregistrement d'image (2) et, par suite, ne transférer que les feuilles d'impression (2) à un appareil de fabrication de plaques d'impression ou clichage.

10. Appareil d'amenage de matière d'enregistrement en feuilles, caractérisé en ce qu'il comprend une pile d'unités composites constituées chacune par une combinaison d'une feuille de matière d'enregistrement d'image (2) à support relativement dur et d'une feuille de séparation (3) placée sur la feuille de matière d'enregistrement et comportant une découpure (a) dans la portion marginale de tête, de façon que la portion marginale de queue de la feuille de séparation (3) fasse saillie au-delà du bord de queue de la feuille de matière d'enregistrement d'image (2), des moyens (4, 4') pour retenir les portions marginales de queue des feuilles de séparation (3) de façon qu'elles ne soient pas transportées, et un dispositif de transport (5) devant agir sur les portions marginales de tête des feuilles de matière d'enregistrement d'image (2) à travers la découpure (a) de la feuille de séparation (3) et donc ne transférer que les feuilles de matière d'enregistrement (2) à un appareil de fabrication de plaques d'impression ou clichage.

**Patentansprüche**

1. Verfahren zum Zuführen von blattförmigen Aufzeichnungsträgern, gekennzeichnet durch das Stapeln von zusammengesetzten Einheiten, von denen jede eine Kombination eines blattförmigen Bildaufzeichnungsträgers (2) mit einem relativ harten Träger und eines Abstandsblattes (3) aufweist, welches auf den blattförmigen Träger gelegt ist, in der Weise, daß der Vorderkantenbereich des blattförmigen Bildaufzeichnungsträgers (2) über die Vorderkante des Abstandsbogens (3) herausragt und der Hinterkantenbereich des Abstandsbogens (3) über die Hinterkante des blattförmigen Bildaufzeichnungsträgers hervorsteht, durch Halten der Hinterkantenbereiche der Abstandsbögen derart, daß sie nicht zugeführt werden, und Anwendung einer Zuführeinrichtung (5) auf die Vorderkantenbereiche des blattförmigen Bildaufzeichnungsträgers, um nur den blattförmigen Träger einer anschließenden Stufe zuzuführen.

2. Verfahren zum Zuführen von blattförmigen Aufzeichnungsträgern, gekennzeichnet durch das Stapel von zusammengesetzten Einheiten, von denen jede eine Kombination eines blattförmigen Bildaufzeichnungsträgers (2) mit einem relativ harten Träger und einem Abstandsbogen (3) aufweist, der auf dem blattförmigen Träger aufgelegt ist und der einen ausgeschittenen oder abgetrennten Bereich (a) im Vorderkantenbereich aufweist, derart, daß der Hinter- oder Rückkantenbereich des Abstandsbogens über die Hinterkante des blattförmigen Bildaufzeichnungsträgers hervorsteht, durch Halten der Rück- oder Hinterkantenbereiche der Abstandsbögen (3) so, daß die nicht zugeführt werden können, und durch Anwendung einer Zuführeinrichtung (5) auf bzw. an die Vorderkantenbereiche des blattförmigen Bildaufzeichnungsträgers (2) über den ausgeschnittenen Bereich (a) des Abstandsbogens (3), um nur das bogenförmige Material (3) einer nachfolgenden Stufe zuzuführen.

3. Verfahren zum Zuführen von blattförmigen Aufzeichnungsträgern nach Anspruch 1 oder 2, dadurch gekennzeichnet, daß der blattförmige Aufzeichnungsträger ein bogenförmiger Träger für Druckplatten ist.

4. Verfahren zum Zuführen von blattförmigen Aufzeichnungsträgern nach einem der vorhergehenden Ansprüche, dadurch gekennzeichnet, daß der Träger ein Metallbogen, wie z.B. ein Aluminiumbogen, ist.

5. Verfahren zum Zuführen von blattförmigen Aufzeichnungsträgern nach einem der vorhergehenden Ansprüche, dadurch gekennzeichnet, daß die zusammengesetzten Einheiten so plaziert sind, daß sie an der Vorderkante relativ zur Achse der Zuführungsebene abwärts geneigt sind.

6. Verfahren zum Zuführen von blattförmigen Aufzeichnungsträgern nach einem der vorhergehenden Ansprüche, dadurch gekennzeichnet, daß die Zuführungseinrichtung eine Sauggreifvorrichtung ist.

7. Verfahren zum Zuführen von blattförmigen Aufzeichnungsträgern nach Anspruch 5, dadurch gekennzeichnet, daß die zusammengesetzten Einheiten in einem Einsatz (1) oder flachen Kasten angeordnet sind, der an der Vorderkante nach unten geneigt ist.

8. Verfahren zum Zuführen von blattförmigen Aufzeichnungsträgern nach einem der vorhergehenden Ansprüche, dadurch gekennzeichnet, daß der blattförmige Bildaufzeichnungsträger (2) einem Belichtungsabschnitt zugeführt wird.

9. Vorrichtung zum Zuführen von blattförmigen Aufzeichnungsträger, welche einen Stapel von zusammengesetzten Einheiten umfaßt, dadurch gekennzeichnet, daß jede der Einheiten eine Kombination aus einem blattförmigen Bildaufzeichnungsträger (2) mit einem relativ Träger und mit einem Abstandsbogen (3), der auf den bogenförmigen Träger in der Weise aufgelegt ist, daß der Vorderkantenbereich des blattförmigen Bildaufzeichnungsträgers (2) über die Vorderkante des Abstandsbogens (3) herausragt, und daß der Hinterkantenbereich des Abstandsbogens (3) über die Hinterkante des blattförmigen Bildaufzeichnungsträgers (2) herausragt, daß eine Einrichtung (4, 4') vorgesehen ist, um die Hinterkantenbereiche des Abstandsbogens (3) zu halten, so daß sie nicht zugeführt werden können, und daß eine Zuführeinrichtung (5) vorgesehen ist, um auf die Vorderkantenbereiche des blattförmigen Bildaufzeichnungsträgers (2) zu wirken und um somit nur das blattförmige Material (2) einem Gerät zuzuführen, welches eine Druckplatte anfertigt.

10. Vorrichtung zum Zuführen von blattförmigen Aufzeichnungsträgern, welches einen Stapel von zusammengesetzten Einheiten umfaßt, dadurch gekennzeichnet, daß jede der Einheiten eine Kombination eines blattförmigen Bildungsaufzeichnungsträgers (2) mit einem relativ harten Träger und einem Anstandsbogen (3) aufweist, der auf den blattförmigen Träger gelegt ist und einen ausgeschnittenen Bereich (a) im Vorderkantenbereich aufweist, derart, da der Hinterkantenbereich des Abstandsbogens (3) über die Hinterkante des blattförmigen Bildaufzeichnungsträgers (2) herausragt, daß eine Einrichtung (4, 4') vorgesehen ist, um die Hinterkantenbereiche des Abstandsbogens (3) zu halten, so daß sie nicht zugeführt werden können, und daß eine Zuführeinrichtung (5) vorgesehen ist, um auf die Vorderkantenbereiche des blattförmigen Bildaufzeichnungsträgers (2) über den ausgeschnittenen Bereich (a) des Abstandsbogens (3) zu wirken und um somit nur den blattförmigen Träger (2) einem Gerät zuzuführen, welches eine Druckplatte anfertigt.

FIG. 1

FIG. 2

FIG. 3

FIG. 4

FIG. 5(A)

FIG. 5(B)